# EUROPEAN PATENT APPLICATION

(11) **EP 4 769 164 A1**
(43) Date of publication of application: **01.07.2026**
(21) Application number: 25221882.1
(22) Date of filing: 09.12.2025
(51) Int. Cl.: G06F 13/42, G11C 7/10

(54) **NOVEL RESOURCE-OPTIMIZED SOURCE SYNCHRONOUS DATA TRANSFER**

(30) Priority: 27.12.2024 IN 202441103876
(71) Applicant: NXP USA, Inc., Austin, TX 78735 (US)
(72) Inventor: Jarrar, Anis Mahmoud, 5656AG Eindhoven (NL); Fullerton, Mark Norman, 5656AG Eindhoven (NL); Agarwal, Amol, 5656AG Eindhoven (NL); Mangal, Himanshu, 5656AG Eindhoven (NL)
(74) Representative: Schwarzweller, Thomas

(57) **Abstract**

An integrated circuit and associated method of operation are provided for a target component coupled over a bus having multiple data path lines and a clock path line to an initiator component which generates a plurality of data bit signals and a first clock timing signal for transmission in parallel over the bus, where the initiator component includes transmit circuitry to launch a first plurality of even data bit signals over a first subset of the plurality of data path lines in response to a rising clock edge of the first clock signal and to launch a second plurality of odd data bit signals over a second subset of the plurality of data path lines in response to a falling clock edge of the first clock signal.

## Description

### BACKGROUND OF THE INVENTION

### Field of the Invention

The present disclosure is directed in general to the field of serial interface communications. In one aspect, the present disclosure relates to a method and apparatus for synchronous data transfer in integrated circuit devices.

### Description of the Related Art

Leading edge system-on-chip (SoC) devices have significant design and performance challenges due to the increasing complexity requirements of integrating multiple cores, DRAM interfaces and large SRAMs to meet ultra-fast computing needs. With the integration of multiple system components (e.g., CPU, GPU and other IP blocks) onto a single chip, communications and transaction handling between system components is increasingly a system performance constraint which limits the achievable performance of SoCs, no matter the optimization of the individual system components. Existing interconnect solutions for communicating between system components typically involve an interconnect topology and design which connects initiator and target components, including but not limited to the Advanced extensible Interface (AXI) on-chip communication bus protocol, the Synchronous Serial Interface (SSI) serial interface protocol, the AMBA Domain Bridge (ADB) asynchronous bridge protocol, or the AXI Async serial interface. With such interconnect protocols, the challenge is to balance the power, performance, and area (PPA) with the performance (throughput, frequency) and convergence predictability (time to market, working silicon, etc.). For example, a source synchronous interface is a type of interface that sends a copy of a clock signal along with data signals to simplify the interface's timing model for communicating data between an initiator (e.g., controller) and a target (e.g., sensor) which brings physical design convergence predictability with reasonable performance, but at the expense of huge circuit area overhead and custom implementation requirements. As seen from the foregoing, existing SoC interconnect solutions are extremely difficult at a practical level by virtue of the challenges with managing the tradeoffs between performance, complexity, convergency predictability, and circuit area which is a combination of both logic count and for the top level structure wiring area - the latter can dominate in some cases. Further limitations and disadvantages of conventional processes and technologies will become apparent to one of skill in the art after reviewing the remainder of the present application with reference to the drawings and detailed description which follow.

### BRIEF DESCRIPTION OF THE DRAWINGS

The present invention may be understood, and its numerous objects, features and advantages obtained, when the following detailed description of a preferred embodiment is considered in conjunction with the following drawings.
Figure 1 depicts a simplified block diagram of a PLL clocking scheme in a conventional SSI interconnection system.
Figure 2 depicts a simplified block diagram of a conventional SSI bus scheme with an initiator domain, source sync domain, and target domain.
Figure 3 depicts a simplified block diagram of a conventional SSI bus scheme with SSI signal grouping.
Figure 4 depicts a timing diagram illustration of a conventional SSI bus timing specifications for an SSI transmitter and SSI receiver.
Figure 5 depicts a simplified block diagram of a conventional SSI transmitter which launches all bits of an SSI group together on a rising clock edge with a conventional SSI receiver which captures launched bits of the SSI group together on a falling clock edge.
Figure 6 depicts a simplified block diagram of an SSI transmitter which launches alternating bits of an SSI group on, respectively, rising and falling clock edges of a clock signal, and an SSI receiver which captures alternating bits of the SSI group together on, respectively, falling and rising clock edges of the clock signal in accordance with selected embodiments of the present disclosure.
Figure 7 depicts a simplified block diagram of a conventional SSI transmitter and SSI receiver with axial shielding lines and staggered transport line buffers to protect against interference caused by timing window alignment when all bits of an SSI group are launched together on a shared clock edge.
Figure 8 depicts a simplified block diagram of an SSI transmitter and SSI transmitter without axial shielding lines and with aligned transport line buffers in accordance with selected embodiments of the present disclosure.
Figure 9 depicts a simplified block diagram illustrating a high level data flow architecture of a resource optimized source synchronous data transfer system in accordance with selected embodiments of the present disclosure.

### DETAILED DESCRIPTION

A high-performance source synchronous data transfer method and apparatus are described for SSI data bus signal routing between initiator and target components with minimum allowed wire spacing by alternating the data launch and data capture timing windows of adjacent SSI signal wires. In selected embodiments, the disclosed SSI data bus signal routing at each initiator device is implemented by configuring alternating bits of each SSI group for data launch at, respectively, the positive and negative clock edges. In similar fashion, the disclosed SSI data bus signal routing at each target device is implemented by configuring alternating bits of each SSI group for data capture at, respectively, the negative and positive clock edges. By alternating the data launch and data capture timing windows of adjacent SSI signal wires, capacitive coupling effects between adjacent SSI signal wires are eliminated, thereby improving signal integrity and reducing SSI circuit area overhead associated with the wiring that is otherwise required to shield against coupling effects. Additional benefits of the disclosed high-performance source synchronous data transfer method and apparatus include reducing design constraints for scatter buffer placement along the SSI data signal paths since, by alternating data launch and data capture timing windows of adjacent SSI signal wires, there are no longer IR concerns posed by aligning buffer placements along the SSI data signal paths.

In this disclosure, an improved SSI data bit signalling circuit, design, structure, and method of operation are described to address various problems in the art where various limitations and disadvantages of conventional solutions and technologies will become apparent to one of skill in the art after reviewing the remainder of the present application with reference to the drawings and detailed description provided herein. Various illustrative embodiments of the present invention will now be described in detail with reference to the accompanying figures. While various details are set forth in the following description, it will be appreciated that the present invention may be practiced without these specific details, and that numerous implementation-specific decisions may be made to the invention described herein to achieve the device designer's specific goals, such as compliance with process technology or design-related constraints, which will vary from one implementation to another. While such a development effort might be complex and time-consuming, it would nevertheless be a routine undertaking for those of ordinary skill in the art having the benefit of this disclosure. For example, selected aspects are depicted with reference to simplified schematic circuit and block diagram drawings without including every device feature or geometry in order to avoid limiting or obscuring the present invention. Such descriptions and representations are used by those skilled in the art to describe and convey the substance of their work to others skilled in the art. It is also noted that, throughout this detailed description, certain elements in the figures are illustrated for simplicity and clarity and have not necessarily been drawn to scale. Further, reference numerals have been repeated among the drawings to represent corresponding or analogous elements.

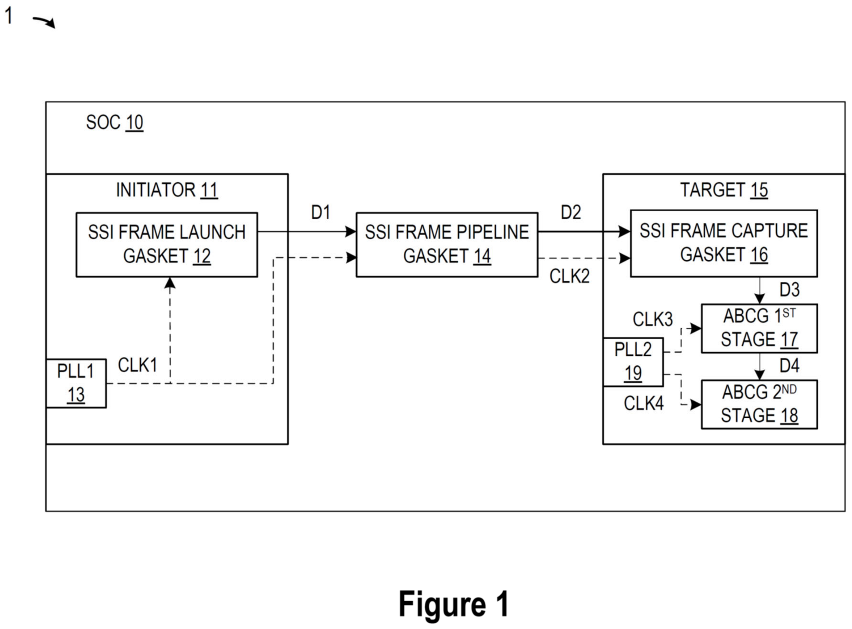

For an improved contextual understanding the present disclosure, reference is now made to Figure 1 which depicts a simplified block diagram of an SoC 10 employing a conventional SSI interconnection system with a PLL clocking scheme wherein an initiator component 11 having a first PLL clock source 13 conveys data and clock signals to a target component 15 having a second PLL clock source 19. The depicted initiator component 11 includes an SSI frame launch gasket 12 which is connected to receive a first clock signal CLK1 from the first PLL clock source 13, and to generate output data D1. Though not shown, it will be appreciated that the SSI frame launch gasket 12 includes any suitable circuitry for launching output data D1 on the positive edges of the first clock signal CLK1, such as a data serializer circuit, buffer(s), shifters, and a plurality of data storage flip-flops. In this way, the initiator 11 generates the output data D1 and first clock signal CLK1 for transmission to the SSI frame pipeline gasket 14. In response, the SSI frame pipeline gasket 14 forwards the output data D2 and a clock signal CLK2 to the target component 15. The depicted target component 15 includes an SSI frame capture gasket 16 which is connected to receive and process the output data D2 and second clock signal CLK2 and to generate output data D3. Though not shown, it will be appreciated that the SSI frame capture gasket 16 includes any suitable circuitry for capturing the output data D2 on the falling edges of the second clock signal CLK2, such as an amplifier, delay equalizer, data sampler, and deserializer circuit. To process skew in the received output data D2 and second clock signal CLK2, the target component 15 may also include a first stage Async Bridge Capture Gasket (ABCG) 17 and second stage ABCG 18 for sequential processing the output data D3. The depicted first and second stage ABCGs 17, 18 are respectively connected to receive clock signals CLK3, CLK4 from the second PLL clock source 19. In operation, the SSI frame launch gasket 12 at the initiator component 11 is configured to implement a synchronous serial interface protocol by launching sequential data bits of the output data D1 on the rising edges of the first clock signal CLK1. In addition, the SSI frame capture gasket 16 at the target component 15 is configured to implement a synchronous serial interface protocol by capturing sequential data bits of the output data D2 on the falling edges of the second clock signal CLK2.

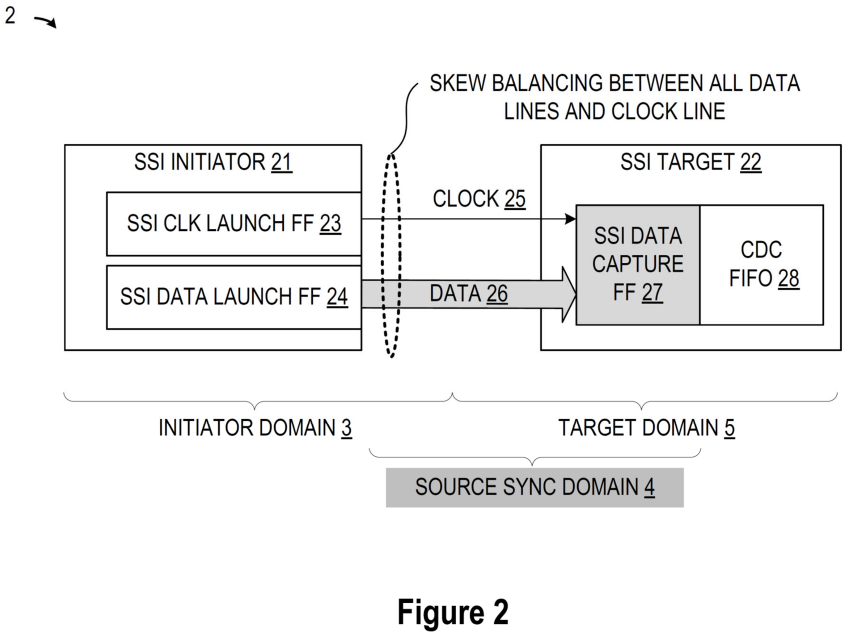

For an improved contextual understanding the present disclosure, reference is now made to Figure 2 which depicts a simplified block diagram 2 of a conventional SSI interconnection system with an SSI initiator component 21 connected to transmit data 26 and clock 25 signals over a source synchronous bus to an SSI target component 22. As depicted, the functionality of the SSI bus scheme may be divided into an initiator domain 3, source sync domain 4, and target domain 5. In the initiator domain 3, the SSI initiator component 11 includes an SSI clock launch flip-flop 23 (which generates the output clock signal 25) and a plurality of SSI data launch flip-flops 24 (which generates the output data signal 26 on the rising edges of the output clock signal 25). In the source sync domain 4, a source synchronous bus is used to carry the output data signal 26 across the chip in parallel to the output clock signal 25. In the target domain 5, the SSI target component 21 includes a Clock Domain Crossing (CDC) module which may be a specialized First In First Out (FIFO) buffer that handles data transfer between different clock domains. However, the SSI target component 21 also includes an SSI data capture flip-flop 27 from the source sync domain 4 which samples the received output data signal 26 using the supplied output clock signal 25 across to a local frequency source which may have an unrelated frequency or phase to the supplied output clock signal 25. As described more fully hereinbelow, source sync domain 4 must address any skew balancing requirements between multiple data signals 26 and the shared clock signal 25 by requiring a 50% time period as the hold margin and a 50% time period as the setup margin at the SSI data capture flip-flop 27.

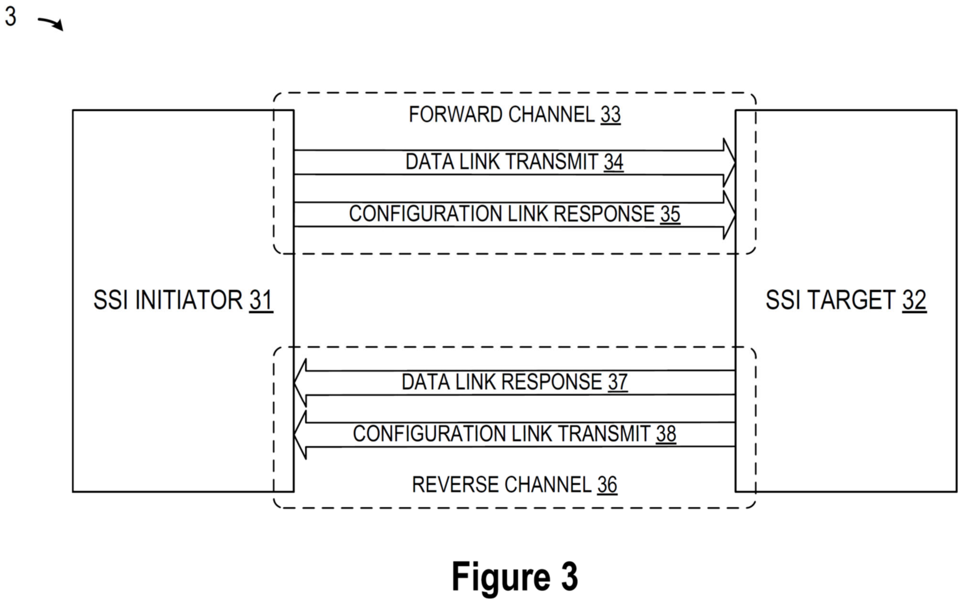

For an improved contextual understanding the present disclosure, reference is now made to Figure 3 which depicts a simplified block diagram 3 of a conventional SSI interconnection system with SSI signal grouping for an SSI initiator 31 and SSI target 43 communicating over a forward channel 33 and reverse channel 36. In the depicted forward channel 33, the SSI bus width can include any number of bits (e.g., 256 bits, 1024 bits, etc.) which may be divided into multiple groups, where each group includes multiple data lanes or paths (e.g., bits 0-15) with control lanes (e.g., bits 0-4) and a clock lane. Thus, the SSI initiator 31 transmits each SSI signal group over the forward channel 33 to the SSI target 32 over the data link transmit lines 34 in parallel with the configuration link response lines 35. Upon reception, the SSI target 32 processes each SSI signal group to balance the group of signals so that the bus signals and clock have paths that are closely matched. In similar fashion, the SSI target 32 transmits each SSI signal group over the reverse channel 36 to the SSI initiator 31 over the data link response lines 37 in parallel with the configuration link transmit lines 38, and the SSI initiator 31 processes each SSI signal group to de-skew and balance the group of signals.

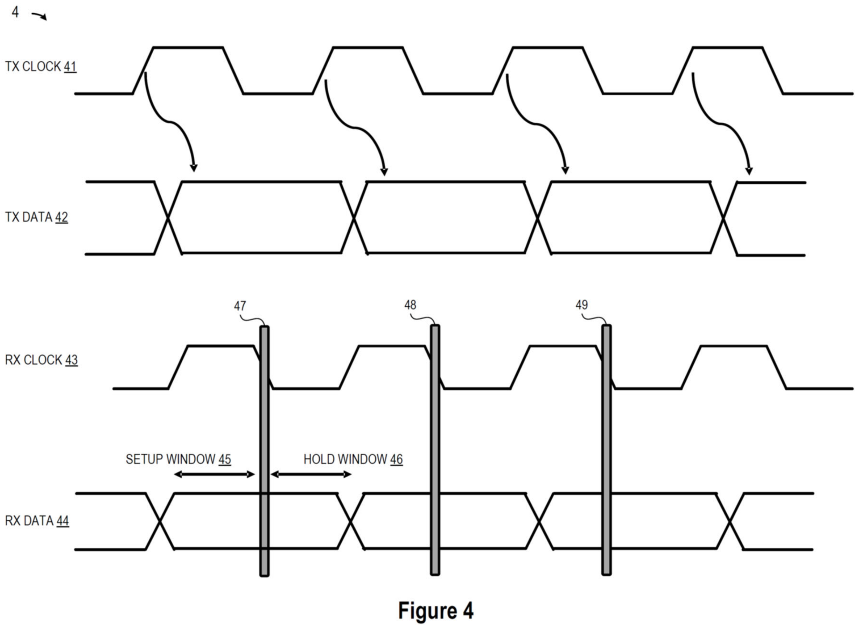

For an improved contextual understanding the present disclosure, reference is now made to Figure 4 which depicts a timing diagram illustration 5 of SSI bus timing specifications for an SSI transmitter and SSI receiver. At the SSI transmitter, the transmit data waveform 42 shows that each data bit is launched at the positive or rising edge of the transmit clock signal 41 so that the data 42 and clock 41 are sent in edge-aligned fashion. At the SSI receiver, the receiver data waveform 44 shows that each bit is captured or latched at the negative or falling edge of the receiver clock signal 43. With the SSI signalling arrangement, the SSI receiver has a setup window 45 that is approximately one half of a clock cycle, and has a hold window 46 that is approximately one half of the clock cycle when latching occurs. While the setup and holding windows 45, 46 allow the receiver data 44 to be accurately received with relatively low frequency clock signals (e.g., 3 ns clock cycles), there are data reception problems that arise with higher frequency clock signals (e.g., 300 picosecond clock cycles), especially when multiple data signals are being received in parallel as part of an SSI signal group (e.g., a 23 bit bundle including 22 data signals D0-D22 and a clock signal). The data reception challenges are exacerbated by the capacitive coupling effects between adjacent SSI data lines in an SSI signal group that can negatively impact signal integrity and create skew between the clock and data lines. Other factors that can create skew include the number, positioning, and construction of buffers in the SSI bus which connects the SSI initiator and target components. For example, if a clock signal is conveyed over an upper, higher capacitance metal line of the SSI bus while one or more data signals are conveyed over a lower, lower capacitance metal line of the SSI bus, the clock and data signals may have skewed arrival times at the target component. Even when clock and data signal paths are designed on the same metal layer, there can be variations that arise because the lengths of the clock and data signal paths cannot be identical in their routing between the initiator and target components. Another factor contributing to skew is the local variation that occurs between different buffers used in the clock and data signal paths. This local variation at each buffer gets magnified with each buffer along the clock and data signal paths. As will be appreciated by those skilled in the art, significant levels of data skew can eat into the setup criticality or hold criticality or both.

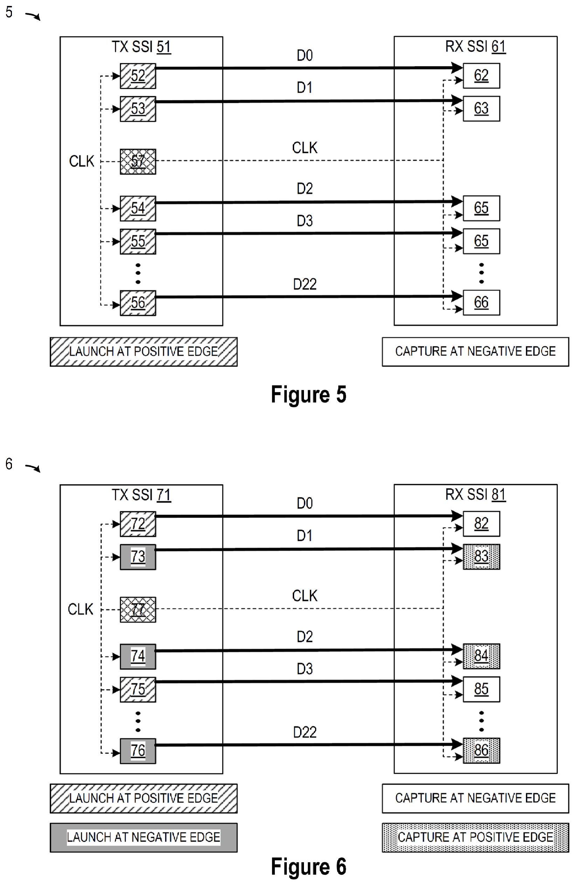

For an improved contextual understanding the present disclosure, reference is now made to Figure 5 which depicts a simplified block diagram 5 of a conventional SSI transmitter 51 which launches all data bits of an SSI group D0-D22 together on a rising edge of the clock signal CLK with a conventional SSI receiver 61 which captures launched bits of the SSI group together on a falling edge of the clock signal CLK. The depicted SSI transmitter 51 includes a plurality of SSI frame launch gaskets 52-56 which are each connected to receive a clock signal CLK from the clock source 57 (indicated in cross-hatched shading), thereby generating a corresponding plurality of output data signals D0-D22. In the depicted SSI transmitter 51, each of the output data signals D0-D22 is launched on a positive or rising edge of the clock signal CLK (as indicated by the angled pattern shading). In similar fashion, the depicted SSI receiver 61 includes a plurality of SSI frame capture gaskets 62-66 which are each connected to receive the clock signal CLK from the clock source 57, and to capture or latch the corresponding plurality of output data signals D0-D22 on a negative or falling edge of the clock signal CLK (as indicated by the solid white boxes). With the arrangement of alternating the clock edges for launching and receiving adjacent bits, there is an idealized scenario which enables a T/2 window for setup and T/2 window for hold.

As will be appreciated by those skilled in the art, there are significant capacitive coupling effects that arise from multiplexing multiple channels together on the SSI data lines D0-D22 that can negatively impact signal integrity and create skew between the clock and data lines. For example, simultaneous signal toggling on the output data signals D0-D22 can result in capacitive coupling effects between adjacent SSI data lines that can create skew between the clock and data lines, especially in situations where the SSI bus is used to provide a high frequency interface and data transport between initiator and target components separated from one another over long spans on the SoC device. Efforts to mitigate such skew by using custom routing (same layer, equidistant buffers) for the SSI bus adds to the design and construction complexity. Other skew mitigation solutions, such as adding signal shield lines between data signal paths or scattering the placement of buffers along the data signal paths, put additional constraints and costs on physical design of the SoC devices. All these constraints increase the cost and size of SSI implementation in terms of area overhead.

To provide an improved understanding of selected embodiments of the present disclosure, reference is now made to Figure 6 which depicts a simplified block diagram 6 of a resource optimized source synchronous data transfer system having an SSI transmitter 71 which launches alternating data bits of an SSI group D0-D22 on, respectively, rising and falling clock edges of the clock signal CLK, and an SSI receiver 81 which captures alternating bits of the SSI group together on, respectively, falling and rising clock edges of the clock signal CLK. The depicted SSI transmitter 71 includes a plurality of SSI frame launch gaskets 72-76 which are each connected to receive a clock signal CLK from the clock source 77 (indicated in cross-hatched shading) and to generate a corresponding plurality of output data signals D0-D22. In the depicted SSI transmitter 71, a first group of alternating or "odd" SSI frame launch gaskets (e.g., 72, 75) are configured to launch and generate output data signals (e.g., D0, D3) on a positive or rising edge of the clock signal CLK (as indicated by the angled pattern shading), and a second group of alternating or "even" SSI frame launch gaskets (e.g., 73, 74, 76) are configured to launch and generate output data signals (e.g., D1, D2, D22) on a negative or falling edge of the clock signal CLK (as indicated by the gray shading). In similar fashion, the depicted SSI receiver 81 includes a plurality of SSI frame capture gaskets 82-86 which are each connected to receive the clock signal CLK from the clock source 77 and to capture or latch the plurality of output data signals D0-D22. In this arrangement, the "even" SSI frame launch gaskets transmit data output signals while the "odd" SSI frame launch gaskets are silent. And instead of latching all the output data signals D0-D22 on a falling clock edge as shown in Figure 5, the SSI receiver 81 includes a first group of alternating or "odd" SSI frame capture gaskets (e.g., 82, 85) that are configured to capture or latch the output data signals (e.g., D0, D3) on a negative or falling edge of the clock signal CLK (as indicated by the solid white boxes), and a second group of alternating or "even" SSI frame capture gaskets (e.g., 83, 84, 86) that are configured to capture or latch output data signals (e.g., D1, D2, D22) on a positive or rising edge of the clock signal CLK (as indicated by the dotted shading). With the arrangement of alternating the clock edges for launching and receiving adjacent bits, there is an idealized scenario which enables a T/2 timing window shift between adjacent bits.

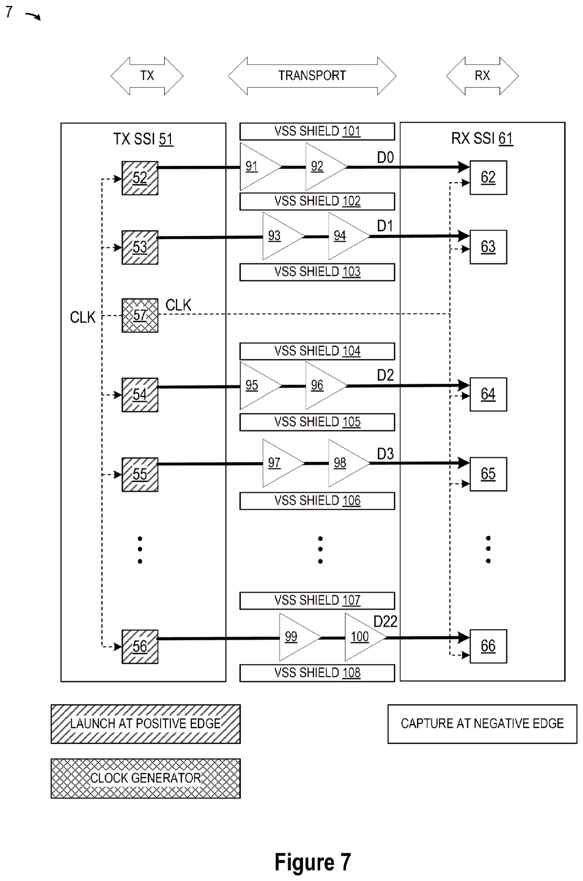

For an improved contextual understanding the present disclosure, reference is now made to Figure 7 which depicts a simplified block diagram 7 of a conventional SSI transmitter 71 which is connected to transmit an SSI group D0-D22 over a plurality of transport data link lines to the SSI receiver 61 by simultaneously launching all data bits on the rising edge of the clock signal CLK and simultaneously capturing all data bits on the falling edge of the clock signal CLK. Since the operational design and details of the depicted SSI transmitter 51 and SSI receiver 61 are identical to the disclosure provided in Figure 5, they will not be repeated for purposes of brevity. However, the transport data link lines between the SSI transmitter 51 and SSI receiver 61 include additional circuit features for purposes of supporting and protecting SSI data transmission. In particular, a plurality of axial shielding lines 101-108 are disposed along both sides of each transport data link line to protect against interference caused by adjacent transport data link lines. Each of the axial shielding lines 101-108 is shown as a linear element that is connected to a Vss reference voltage, but it will be appreciated that any fixed voltage connected to the axial shielding lines 101-108 will provide shielding benefits. In addition, it will be appreciated that the axial shielding lines will have any suitable shape that is disposed to be laterally spaced apart by a uniform spacing distance from each transport data link line that is being protected. The addition of axial shielding lines 101-108 imposes a very high routing overhead cost in terms of the larger circuit area required to interleave the axial shielding lines 101-108 between the transport data link lines.

An additional feature of the transport data link lines is the inclusion of buffers 91-100 which are spaced apart equidistantly to reduce skew by keeping the signal level elevated over the length of the transport data link line. For example, the transport data link line for output data D0 includes equidistant buffers 91, 92 positioned between the SSI frame launch gasket 52 and SSI frame capture gasket 62. However, the power delivery network which powers the buffers 91-100 creates additional interference on the transmission of output data signals D0-D22 when there is a power drop at an individual buffer during switching of the output data signal. The resulting disturbance noise on the power supply creates a power integrity issue that can affect buffers on adjacent transport data line lines. Conventional solutions for addressing the power integrity issue caused by buffers include staggering the buffers along each transport data link line so that they are not aligned with buffers of an adjacent transport data link line. For example, the positioning of the equidistant buffers 93, 94 on the second transport data link line for output data D1 are staggered with respect to the positioning of the equidistant buffers 91, 92 on the first transport data link line for output data D0. While the staggered buffer design helps address the power drop issue, it negatively affects the skew performance. With the interleaved approach, the buffers can be made physically close without impacting the power drop due to the different switching points.

As seen from the foregoing, SSI bus interconnects used for high frequency interfaces and data transport over long span across SoC have a number of design challenges for addressing skew balancing of the clock and data that is transported from the SSI transmitter 51 to the SSI receiver 61. Conventional skew balancing solutions require expensive custom routing features, such as routing all data signals on the same layer, equidistant spacing of buffers, and axial shielding lines, to mitigate signal integrity and power interference issues that arise with high throughput, multiple channel SSI bus interconnects having very high frequency, simultaneous signal toggling. All these constraints result in SSI implementations that are very costly in terms of area overhead (e.g., over 5% of overall die size for SSI signal overhead).

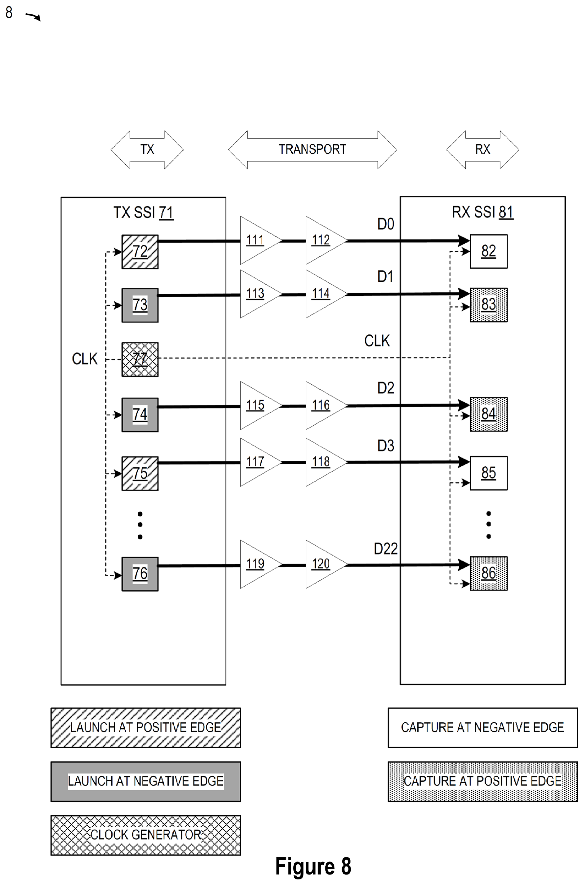

To address these design challenges and others known to those skilled in the art, reference is now made to Figure 8 which depicts a simplified block diagram 8 of a resource optimized source synchronous data transfer system having an SSI transmitter 71 which launches alternating data bits of an SSI group D0-D22 on, respectively, rising and falling clock edges of the clock signal CLK, and an SSI receiver 81 which captures alternating bits of the SSI group together on, respectively, falling and rising clock edges of the clock signal CLK. Since the operational design and details of the depicted SSI transmitter 71 and SSI receiver 81 are identical to the disclosure provided in Figure 6, they will not be repeated for purposes of brevity. However, the transport data link lines between the SSI transmitter 71 and SSI receiver 81 are implemented with a compact layout that does not include axial shielding lines interspersed between the transport data link lines. As disclosed herein, the elimination of the axial shielding lines is made possible because the alternating timing of data launch on adjacent output data paths mitigates any signal coupling interference concerns. In addition, the buffers 111-120 that are included along the transport data link lines are aligned with each other so that there is no staggered positioning of buffers. For example, the positioning of the equidistant buffers 111, 112 on the first transport data link line for output data D0 are aligned with respect to the positioning of the equidistant buffers 113, 114 on the second transport data link line for output data D1. As disclosed herein, the aligned buffer design has a positive impact on skew performance with reduced circuit area overhead cost, but does not suffer from power drop concerns because the alternating timing of data launch on adjacent output data paths mitigates any power interference concerns. In addition, the elimination of the axial shielding lines reduces the overhead cost by providing a more compact circuit area for the SSI bus interconnect since alternate bits are toggling T/2 phase shift apart, resulting in no aggressor-victim signal interference scenario.

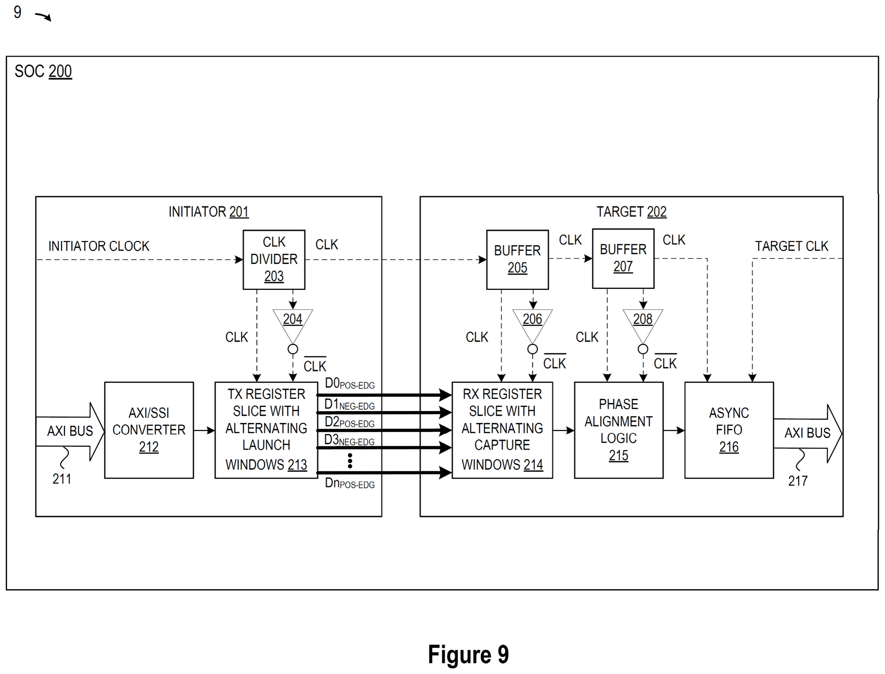

For an improved understanding of selected embodiments of the present disclosure, reference is now made to Figure 9 which depicts a simplified block diagram 9 illustrating a high level data flow architecture of a resource optimized source synchronous data transfer system in an SoC device 200 which reliably transfers data synchronously across an SoC device over long SSI bus interconnects by adjusting the timing window of alternating SSI data bus lines to eliminate cross-signal interference from adjacent bits on the SSI bus. As depicted, the SoC device 200 includes an initiator 201 which launches alternating data bits of an SSI group D0-Dn on, respectively, positive (rising) and negative (falling) clock edges of the clock signal CLK. The SoC device 200 also includes a target 202 which captures alternating bits of the SSI group D0-Dn on, respectively, negative (falling) and positive (rising) clock edges of the clock signal CLK.

In the initiator 201, input data is received on an input bus protocol (e.g., a multi-bit ARM extensible interface (AXI) bus or AMBA bus) 211, where the input data could be provided on a multi-bit wide bus (e.g., 256 bits). At the AXI/SSI converter 212, the input data is converted to the SSI bus protocol and then conveyed to the TX register slice unit 213. At the TX register slice unit 213, the received SSI protocol input data is divided or sliced into data slices or bundles of a predetermined width (e.g., 16 data bits). In addition, the TX register slice unit 213 stores alternating data bits from each slice or bundle in a plurality of launch gaskets or flops which are separately clocked with either the clock signal CLK or inverted clock signal (CLK),̅ thereby providing alternating launch windows. To achieve the desired alternating launch windows, the initiator 201 includes a clock divider circuit 203 which is connected to receive an initiator clock signal and to generate the clock signal CLK. Applying the clock signal CLK to the inverter 204, an inverted clock signal (CLK) is generated and applied with the clock signal CLK to the TX register slice unit 213. In embodiments where the plurality of launch gaskets or flops are operatively configured to respond to a positive (or rising) edge clock signal, then the clock signal CLK and inverted clock signal (CLK) are alternately connected to alternating launch gaskets or flops, thereby effectively providing alternating launch windows for the adjacent data lines in each slide. In the depicted example, the TX register slice unit 213 may be configured to generate "even" data outputs (e.g., D0POS-EDG, D2 POS-EDG, Dn POS-EDG) on the positive edge of the clock signal CLK by clocking positive-edge triggered flops with the clock signal CLK, and may be configured to generate "odd" data outputs (e.g., D1NEG-EDG, D3 NEG-EDG) on the negative edge of the clock signal CLK by clocking positive-edge triggered flops with the inverted clock signal (CLK).̅

At the target 202, the clock signal CLK and data outputs D0POS-EDG- DnPOS-EDG are received and processed to reconstruct the alignment of the data output signals. In particular, the target 202 includes a buffer 205 which is connected to receive the transported clock signal CLK and to generate the buffered clock signal CLK which is applied to the inverter 206 to generate the inverted clock signal (CLK).̅ The clock signal CLK and inverted clock signal (CLK) are then supplied to the RX register slice unit 214. At the RX register slice unit 214, the received data outputs D0POS-EDG- DnPOS-EDG are captured with plurality of capture gaskets or flops which are separately clocked with either the clock signal CLK or inverted clock signal (CLK),̅ thereby providing alternating capture windows. In addition, the RX register slice unit 214 combines the captured data bits from multiple data slices or bundles into a multi-bit output data of a predetermined width (e.g., 256 output data bits). The multi-bit output data is then provided to the phase alignment logic unit 215 which is connected and configured to re-align the data outputs (D0POS-EDG- DnPOS-EDG) for output as SSI formatted data using the clock signal CLK and inverted clock signal (CLK) generated by the buffer 207 and inverter 208. In effect, the phase alignment logic unit 215 does phase re-alignment to present all bits to the target 202 in the same phase. The SSI formatted output data is then provided to the asynchronous FIFO 216 which is connected and configured to complete the format conversion of SSI formatted output data to the AXI formatted output data to the AXI bus 217 using the clock signal CLK and target clock signal.

As seen from the foregoing, there is disclosed herein a novel SSI data transfer interface and architecture which adjusts the launch/capture timing windows of adjacent data bus lines to eliminate cross signal interference from other bus lines on same bus, thereby reducing die size overhead by obviating need of shielding by enabling non-overlapping timing window for adjacent bits. In addition to die size saving, the disclosed SSI data transfer interface and architecture reduces insertion delay by eliminating the requirement of shielding lines which add to ground capacitance. In addition, the disclosed SSI data transfer interface and architecture mitigates IR drop concerns since there is no overlapping data bit toggling on adjacent data bus lines. The disclosed SSI data transfer interface and architecture also improves skew performance by eliminating the buffer staggering requirement. In addition, the disclosed SSI data transfer interface and architecture is backward compatible with previous generation SSI protocols with flexibility to adjust the data bus timing window with more aggressive options as per physical design constraints.

An integrated circuit and associated method of operation are provided for a target component coupled over a bus having multiple data path lines and a clock path line to an initiator component which generates a plurality of data bit signals and a first clock timing signal for transmission in parallel over the bus, where the initiator component includes transmit circuitry to launch a first plurality of even data bit signals over a first subset of the plurality of data path lines in response to a rising clock edge of the first clock signal and to launch a second plurality of odd data bit signals over a second subset of the plurality of data path lines in response to a falling clock edge of the first clock signal.

By now, it should be appreciated that there has been provided an integrated circuit design, apparatus, architecture, and method of operation for an integrated circuit which includes an initiator component coupled over a bus to a target component. In selected embodiments, the initiator component is selected from a group consisting of a core, a controller, a central processing unit (CPU), a microprocessor unit (MPU), a graphics processing unit (GPU), or a vector processing unit (VPU), a direct memory access (DMA) controller, or an ethernet controller. The disclosed bus includes a plurality of data path lines and a clock path. In selected embodiments, the bus is a simplex, non-multiplexed bus. In selected embodiments, the target component is a module or device on the integrated circuit which is able to receive a bus access from the initiator component. The disclosed initiator component is configured and connected to generate a plurality of data bit signals and a first clock timing signal for transmission in parallel over the bus which includes a plurality of data path lines and a clock path line. The plurality of data bit signals includes a first group of data bit signals interspersed with a second group of data bit signals. The disclosed initiator component includes transmit circuitry to launch the first group of data bit signals over a first subset of the plurality of data path lines in response to a rising clock edge of the first clock signal and to launch the second group of data bit signals over a second subset of the plurality of data path lines in response to a falling clock edge of the first clock signal. In selected embodiments, the first subset of the plurality of data path lines is interspersed in alternating fashion with the second subset of the plurality of data path lines. In selected embodiments, the target component is configured and connected to capture the first group of data bit signals over the first subset of the plurality of data path lines in response to a falling clock edge of the first clock signal and to capture the second group of data bit signals over the second subset of the plurality of data path lines in response to a rising clock edge of the first clock signal. In other selected embodiments, the plurality of data path lines does not include shielding lines disposed or located between adjacent data path lines of the plurality of data path lines. In selected embodiments, adjacent data path lines in the plurality of data path lines are formed with a minimum metal width and minimum metal spacing to prevent shielding wires from being located between the adjacent data path lines. In other selected embodiments, the plurality of data path lines may be formed with a minimum metal width of about 40 nm or less and minimum metal spacing of about 40 nm or less. In selected embodiments, the first group of data bit signals includes "even" data bit signals (e.g., 00, 02, 04, 06, 08, 10, 12, 14) from the plurality of data bit signals (00-15), and the second group of data bit signals comprises "odd" data bit signals (e.g., 01, 03, 05, 07, 09, 11, 13, 15) from the plurality of data bit signals. As a result of launching the first group of "even" data bit signals over the first subset of data path lines in response to rising clock edges and launching the second group of "odd" data bit signals over the second subset of data path lines in response to falling clock edges, consecutive data bit signals from the plurality of data bit signals are not simultaneously launched on adjacent data path lines. In other embodiments, the first group of data bit signals includes a first plurality of consecutive data bit signals data bit signals (e.g., 00-07) from the plurality of data bit signals (00-15), and the second group of data bit signals includes a second plurality of consecutive data bit signals (e.g., 08-15) from the plurality of data bit signals. As a result of launching the first group of consecutive data bit signals (00-07) over the first subset of data path lines in response to rising clock edges and launching the second group of consecutive data bit signals (08-15) over the second subset of data path lines in response to falling clock edges, consecutive data bit signals from the plurality of data bit signals are not simultaneously launched on adjacent data path lines

In another form, there is provided an integrated circuit and associated method of operation. In the disclosed method, a first clock timing signal is received at an integrated circuit initiator component, where the first clock timing signal includes a plurality of rising clock edges alternating with a plurality of falling clock edges. The disclosed method also includes receiving a plurality of data bit signals at the integrated circuit initiator component, where the plurality of data bit signals includes a first group of data bit signals and a second group of data bit signals. In addition, the disclosed method includes transmitting the first clock timing signal and the plurality of data bit signals from the integrated circuit initiator component over a plurality of data path lines in a bus and to an integrated circuit target component. As disclosed, the first clock timing signal and the plurality of data bit signals are transmitted by (1) launching the first group of data bit signals for transmission in parallel over a first subset of the plurality of data path lines in the bus to the integrated circuit target component in response to the plurality of rising clock edges of the first clock timing signal, and (2) launching the second group of data bit signals for transmission in parallel over a second subset of the plurality of data path lines in the bus to the integrated circuit target component in response to the plurality of falling clock edges of the first clock timing signal. As disclosed, the first subset of the plurality of data path lines in the bus is interleaved in alternating fashion with the second subset of the plurality of data path lines in the bus. In selected embodiments, the integrated circuit initiator component may be an SoC component selected from a group consisting of a core, a controller, a central processing unit (CPU), a microprocessor unit (MPU), a graphics processing unit (GPU), or a vector processing unit (VPU), a direct memory access (DMA) controller, or an ethernet controller. In other selected embodiments, the bus is a simplex, non-multiplexed bus. In other selected embodiments, the integrated circuit target component is a SoC component which is able to receive a bus access from the initiator component. In selected embodiments, adjacent data path lines in the plurality of data path lines are formed with a minimum metal width and minimum metal spacing to prevent shielding wires from being located between the adjacent data path lines. In such embodiments, the plurality of data path lines is formed with a minimum metal width of about 40 nm or less and minimum metal spacing of about 40 nm or less. In selected embodiments, the disclosed method may also include receiving the first clock timing signal and the plurality of data bit signals at the integrated circuit target component by (1) sampling the first group of data bit signals received over the first subset of the plurality of data path lines in the bus in response to the plurality of falling clock edges of the first clock timing signal, and (2) sampling the second group of odd data bit signals received over the second subset of the plurality of data path lines in the bus in response to the plurality of rising clock edges of the first clock timing signal. In selected embodiments, the disclosed method may also include generating a second clock timing signal by inverting the first clock timing signal at the integrated circuit initiator component, where the second clock timing signal comprises a plurality of second rising clock edges alternating with a plurality of second falling clock edges. In such embodiments, launching the first group of data bit signals may include using the plurality of rising clock edges of the first clock timing signal as a first timing reference to launch the first group of data bit signals for transmission in parallel over the first subset of the plurality of data path lines in the bus. In addition, launching the second group of data bit signals may include using the plurality of second rising clock edges of the second clock timing signal as a second, delayed timing reference to launch the second group of data bit signals for transmission in parallel over the second subset of the plurality of data path lines in the bus. In selected embodiments, the first group of data bit signals includes "even" data bit signals (e.g., 00, 02, 04, 06, 08, 10, 12, 14) from the plurality of data bit signals (00-15), and the second group of data bit signals comprises "odd" data bit signals (e.g., 01, 03, 05, 07, 09, 11, 13, 15) from the plurality of data bit signals. As a result of launching the first group of "even" data bit signals over the first subset of data path lines in response to rising clock edges and launching the second group of "odd" data bit signals over the second subset of data path lines in response to falling clock edges, consecutive data bit signals from the plurality of data bit signals are not simultaneously launched on adjacent data path lines. In other embodiments, the first group of data bit signals includes a first plurality of consecutive data bit signals data bit signals (e.g., 00-07) from the plurality of data bit signals (00-15), and the second group of data bit signals includes a second plurality of consecutive data bit signals (e.g., 08-15) from the plurality of data bit signals. As a result of launching the first group of consecutive data bit signals (00-07) over the first subset of data path lines in response to rising clock edges and launching the second group of consecutive data bit signals (08-15) over the second subset of data path lines in response to falling clock edges, consecutive data bit signals from the plurality of data bit signals are not simultaneously launched on adjacent data path lines

In yet another form, there is provided a System on Chip (SoC) and associated method of operation. As disclosed, the SoC includes a simplex, non-multiplexed interconnect bus comprising a plurality of data path lines and a clock path line. In addition, the SoC includes an initiator component core coupled to the simplex, non-multiplexed interconnect bus. The disclosed SoC also includes a target component core coupled to the simplex, non-multiplexed interconnect bus. In the disclosed SoC, the initiator component is configured to transmit a clock timing signal and a plurality of data bit signals over the plurality of data path lines to the target component by (1) launching a first plurality of even data bit signals for transmission in parallel over a first subset of the plurality of data path lines to the target component in response to a plurality of rising clock edges of the clock timing signal; and (2) launching the first plurality of odd data bit signals for transmission in parallel over a second subset of the plurality of data path lines to the target component in response to a plurality of falling clock edges of the clock timing signal. In the disclosed SoC, the first subset of the plurality of data path lines in the bus is interleaved in alternating fashion with the second subset of the plurality of data path lines in the simplex, non-multiplexed interconnect bus. In addition, adjacent data path lines in the plurality of data path lines are formed with a minimum metal width and minimum metal spacing to prevent shielding wires from being located between the adjacent data path lines. In selected embodiments, the plurality of data path lines is formed with a minimum metal width of about 40 nm or less and minimum metal spacing of about 40 nm or less. In other selected embodiments, the target component is configured to receive the clock timing signal and the plurality of data bit signals by (1) sampling the first plurality of even data bit signals received over the first subset of the plurality of data path lines in response to the plurality of falling clock edges of the first clock timing signal; and (2)sampling the first plurality of odd data bit signals received over the second subset of the plurality of data path lines in response to the plurality of rising clock edges of the first clock timing signal.

Although the described exemplary embodiments disclosed herein are directed to selected SSI data transfer circuits and methods of operation for adjusting the timing window of alternating data bits on an SSI data bus to eliminate cross signal interference from adjacent data bits on same bus, the present invention is not necessarily limited to the example embodiments which illustrate inventive aspects of the present invention that are applicable to a wide variety of circuit configurations. Thus, the particular embodiments disclosed above are illustrative only and should not be taken as limitations upon the present invention, as the invention may be modified and practiced in different but equivalent manners apparent to those skilled in the art having the benefit of the teachings herein. Accordingly, the foregoing description is not intended to limit the invention to the particular form set forth, but on the contrary, is intended to cover such alternatives, modifications and equivalents as may be included within the spirit and scope of the invention as defined by the appended claims so that those skilled in the art should understand that they can make various changes, substitutions and alterations without departing from the spirit and scope of the invention in its broadest form.

A few implementations have been described in detail above, and various modifications are possible. The disclosed subject matter, including the functional operations described in this specification, can be implemented in electronic circuit, computer hardware, firmware, software, or in combinations of them, such as the structural means disclosed in this specification and structural equivalents thereof: including potentially a program operable to cause one or more data processing apparatus such as a processor to perform the operations described (such as a program encoded in a non-transitory computer-readable medium, which can be a memory device, a storage device, a machine-readable storage substrate, or other physical, machine readable medium, or a combination of one or more of them).

While this specification contains many specifics, these should not be construed as limitations on the scope of what may be claimed, but rather as descriptions of features that may be specific to particular implementations. Certain features that are described in this specification in the context of separate implementations can also be implemented in combination in a single implementation. Conversely, various features that are described in the context of a single implementation can also be implemented in multiple implementations separately or in any suitable sub-combination. Moreover, although features may be described above as acting in certain combinations and even initially claimed as such, one or more features from a claimed combination can in some cases be excised from the combination, and the claimed combination may be directed to a sub-combination or variation of a sub-combination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the implementations described above should not be understood as requiring such separation in all implementations.

Use of the phrase "at least one of" preceding a list with the conjunction "and" should not be treated as an exclusive list and should not be construed as a list of categories with one item from each category, unless specifically stated otherwise. A clause that recites "at least one of A, B, and C" can be infringed with only one of the listed items, multiple of the listed items, and one or more of the items in the list and another item not listed.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims. As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus.

## Claims

1. An integrated circuit comprising:
an initiator component configured and connected to generate a plurality of data bit signals and a first clock timing signal for transmission in parallel over a bus comprising a plurality of data path lines and a clock path line to a target component,
where the plurality of data bit signals comprises a first group of data bit signals interspersed with a second group of data bit signals, and
where the initiator component comprises transmit circuitry to launch the first group of data bit signals over a first subset of the plurality of data path lines in response to a rising clock edge of the first clock signal and to launch the second group of data bit signals over a second subset of the plurality of data path lines in response to a falling clock edge of the first clock signal.

2. The integrated circuit of claim 1,
where the initiator component is selected from a group consisting of a core, a controller, a central processing unit (CPU), a microprocessor unit (MPU), a graphics processor unit (GPU), or a vector processing unit (VPU), a direct memory access (DMA) controller, or an ethernet controller; and
where the target component comprises a module or device on the integrated circuit which is able to receive a bus access from the initiator component.

3. The integrated circuit of any preceding claim, where the first group of data bit signals comprises even data bit signals from the plurality of data bit signals, and where the second group of data bit signals comprises odd data bit signals from the plurality of data bit signals.

4. The integrated circuit of any preceding claim, where the first group of data bit signals comprises a first plurality of consecutive data bit signals from the plurality of data bit signals, and where the second group of data bit signals comprises a second plurality of consecutive data bit signals from the plurality of data bit signals.

5. The integrated circuit of any preceding claim, where the first subset of the plurality of data path lines is interspersed in alternating fashion with the second subset of the plurality of data path lines.

6. The integrated circuit of any preceding claim, where the target component is configured and connected to capture the first group of data bit signals over the first subset of the plurality of data path lines in response to a falling clock edge of the first clock signal and to capture the second group of data bit signals over the second subset of the plurality of data path lines in response to a rising clock edge of the first clock signal.

7. The integrated circuit of any preceding claim, where the plurality of data path lines does not include shielding lines disposed or located between adjacent data path lines of the plurality of data path lines.

8. The integrated circuit of any preceding claim, where adjacent data path lines in the plurality of data path lines are formed with a minimum metal width and minimum metal spacing to prevent shielding wires from being located between the adjacent data path lines.

9. The integrated circuit of claim 8, where the plurality of data path lines is formed with a minimum metal width of about 40 nm or less and minimum metal spacing of about 40 nm or less.

10. A method of operating an integrated circuit, comprising:
receiving a first clock timing signal at an integrated circuit initiator component, where the first clock timing signal comprises a plurality of rising clock edges alternating with a plurality of falling clock edges;
receiving a plurality of data bit signals at the integrated circuit initiator component, where the plurality of data bit signals comprises a first group of data bit signals and a second group of data bit signals; and
transmitting the first clock timing signal and the plurality of data bit signals from the integrated circuit initiator component over a plurality of data path lines in a bus and to an integrated circuit target component by:
launching the first group of data bit signals for transmission in parallel over a first subset of the plurality of data path lines in the bus to the integrated circuit target component in response to the plurality of rising clock edges of the first clock timing signal; and
launching the second group of data bit signals for transmission in parallel over a second subset of the plurality of data path lines in the bus to the integrated circuit target component in response to the plurality of falling clock edges of the first clock timing signal;
where the first subset of the plurality of data path lines in the bus is interleaved in alternating fashion with the second subset of the plurality of data path lines in the bus.

11. The method of claim 10, where the integrated circuit initiator component is a System-on-Chip (SoC) component selected from a group consisting of a core, a controller, a central processing unit (CPU), a microprocessor unit (MPU), a graphics processor unit (GPU), or a vector processing unit (VPU), a direct memory access (DMA) controller, or an ethernet controller, and where the integrated circuit target component is a System-on-Chip (SoC) component which is able to receive a bus access from the integrated circuit initiator component.

12. The method of claim 10 or 11, here the first group of data bit signals comprises even data bit signals from the plurality of data bit signals, and where the second group of data bit signals comprises odd data bit signals from the plurality of data bit signals.

13. The method of any of claims 10 to 12, where the first group of data bit signals comprises a first plurality of consecutive data bit signals from the plurality of data bit signals, and where the second group of data bit signals comprises a second plurality of consecutive data bit signals from the plurality of data bit signals.

14. The method of any of claims10 to 13, where adjacent data path lines in the plurality of data path lines are formed with a minimum metal width and minimum metal spacing to prevent shielding wires from being located between the adjacent data path lines.

15. The method circuit of claim 14, where the plurality of data path lines is formed with a minimum metal width of about 40 nm or less and minimum metal spacing of about 40 nm or less.
